# EUROPEAN PATENT SPECIFICATION

(11) **EP 0 959 148 B1**
(45) Date of publication and mention of the grant of the patent: **09.04.2003**
(21) Application number: 97933934.8
(22) Date of filing: 15.07.1997
(51) Int. Cl.: C23C 16/56, C23C 16/02, C23C 16/27, C30B 25/10, H01J 9/02, H01J 1/304, C30B 25/02

(54) **METHOD FOR PRODUCING DIAMOND FILMS USING A VAPOUR-PHASE SYNTHESIS SYSTEM**
VERFAHREN ZUR HERSTELLUNG VON DIAMANDFILMEN UNTER VERWENDUNG EINES DAMPFPHASENSYNTHESESYSTEMS
PROCEDE DE PRODUCTION DE PELLICULES DE DIAMANT FAISANT APPEL A UN SYSTEME DE SYNTHESE EN PHASE GAZEUSE

(30) Priority: 16.07.1996 RU 96113270
(43) Date of publication of application: 24.11.1999
(73) Proprietor: OOO "Vysokie Tekhnologii", Moscow, 119989 (RU)
(72) Inventor: RAKHIMOV, Alexandr Tursunovich, Moscow, 119121 (RU); SUETIN, Nikolai Vladislavovich, Elektrostal, 144005 (RU); SAMORODOV, Vladimir Anatolevich, Nakhabino, 143340 (RU)
(74) Representative: Einsel, Martin, Dipl.-Phys.
(86) International application number: RU9700229
(87) International publication number: WO98002027

(56) References cited:
- EP-A- 0 528 322
- EP-A- 0 528 391
- SU-A- 966 782
- US-A- 3 714 334
- US-A- 5 006 203
- US-A- 5 474 021
- PUPETER N ET AL: "Field emission measurements with mu m resolution on chemical-vapor-deposited polycrystalline diamond films" EIGHTH INTERNATIONAL VACUUM MICROELECTRONICS CONFERENCE (IVMC'95), PORTLAND, OR, USA, 31 JULY-3 AUG. 1995, vol. 14, no. 3, pages 2056-2059, XP001008041 Journal of Vacuum Science & Technology B (Microelectronics and Nanometer Structures), May-June 1996, AIP for American Vacuum Soc, USA ISSN: 0734-211X
- LIU H ET AL: "STUDIES ON NUCLEATION PROCESS IN DIAMOND CVD: AN OVERVIEW OF RECENTDEVELOPMENT" DIAMOND AND RELATED MATERIALS,ELSEVIER SCIENCE PUBLISHERS, AMSTERDAM,NL, vol. 4, no. 10, 1 September 1995 (1995-09-01), pages 1173-1188, XP000627307 ISSN: 0925-9635
- JOHANSSON E ET AL: "Effect of atomic hydrogen on the surface topography of chemically vapour deposited diamond films: An atomic force microscopy study" DIAMOND AND RELATED MATERIALS,NL,ELSEVIER SCIENCE PUBLISHERS, AMSTERDAM, vol. 4, no. 2, 1 February 1995 (1995-02-01), pages 155-163, XP004066682 ISSN: 0925-9635
- PATENT ABSTRACTS OF JAPAN vol. 012, no. 433 (C-543), 15 November 1988 (1988-11-15) & JP 63 159292 A (SHOWA DENKO KK), 2 July 1988 (1988-07-02)

## Description

### FIELD OF THE INVENTION

This invention pertains to a method for forming highly effective films to be used for field electron emitters which could be applied for manufacturing of flat panel displays, electron microscopes, microwave electronics and a number of other applications.

### DESCRIPTION OF THE RELATED ART:

It is known a method for forming amorphous diamond films by laser sputtering ["Diamond-based field emission flat panel displays", Solid State Tech., May, 1995, p.71]. Under this method the film is growing on a cold substrate due to the carbon which is being vaporized from the carbon target is being illuminated by a powerful laser. The shortage of this method is a low emission sites density (10³ per CM² under electric field 20 V/micron), what is too low to produce a full color display with 256 shade grades.["Field Emission Characteristics Requirements for Field Emission Display", 1994 Int'l. Display Res. Conf., Soc. for Info. Display, Oct., 1994.]; and also a complexity, high cost and very essential difficulties under scaling up.

It is known a method for forming diamond films using «hot filament» reactor thermally activating a gas mixture of hydrogen and carbon containing gas ["Synthesis of Diamond Thin Films by Thermal CVD Using Organic Compounds Japanese Journal of Applied Physics, vol.25, N6, 1986, p.L519-L521]. Diamond films have been grown on silicon and other substrates located at gas flow under a highly hot tungsten filament. Acetone, variety of spirit and ether compounds, methane have been used as a carbon containing gas. The carbon containing gas concentration was 0.5 -10%. The substrates were heated to higher 650C, filament to higher 2000C. Under these parameters the films have polycrystalline structure with micron size grains and have no effectively good emission properties.

The base of using of the diamond as cold emitters is a negative affinity of diamond [F.J.Himsel et al. Phys. Rev. B, 20(2) 624, 1979]. All the existing attempts to produce a highly effective electron emitter from polycrystalline diamond films are not to be considered as positive ones, in particular due to the very low emission sites density. Emission sites density of such films was not higher than 10³ per CM², but for obtaining of the full color display it is necessary to reach 10⁵.

### SUMMARY OF THE PRESENT INVENTION

The technical goal is invention of a method for producing films with a highly effective emission properties to be used for cathode manufacturing for the full color displays, exactly to produce nano crystalline diamond films with highly effective emission characteristics.

This goal is reached by the CVD method comprising a heating the metal filaments and substrates under the hydrogen flow, introducing a carbon containing gas into the flow and deposition. diamond film on the substrate in hydrogen - carbon containing gas mixture, evacuating surplus of graphite phase; deposition is going on the substrate heated up to 650-900C through the protective grid screen located between the filament heated up to 1800-2800C and the substrate, under carbon containing gas concentration in gas flow 2-10%; the methane under concentration 2-8% could be used as carbon containing gas in gas flow, and in the case of the silicon substrate before deposition the natural oxide should be removed in hydrogen flow under the filament and the substrate temperatures needed for deposition, the silicon carbide layer should be created on the substrate by introducing in gas flow 5-20% methane during 4-20 minutes, after this the methane concentration should be decreased up to 2-8%, after this there should be a deposition process and evacuating surplus of graphite phase.

This method can produce diamond films both on conductive and insulating substrates, in particular on the silicon substrate which is a good conductor under the used temperature range.

The main role of the protective grid screen is to change the relation between concentrations of chemical radicals near surface of the substrate due to effective recombination on the grid walls some of radicals (especially hydrogen atoms).

The protective grid, which is being placed between the substrate and filaments, is made of a materials resistant to high temperature (up to 1500C) and resistant to sputtering. The area of the plate having holes will normally correspond to about the area of the film to be grown on the substrate. Distance between holes and the diameter of the holes should be properly chosen in order to obtain the maximum grid transparence..
If the diameter of holes is less than 0.1 mm the transparency of the grid decreases, if the holes diameter is more than 5 mm in a grid 1 to 2 mm thick, the effect of the grid on chemical radical concentration near the substrate surface begins to decrease The minimal thickness of the grid is limited only mechanical resistance of the grid. The increasing of the thickness resulted in enhancement of grid role on the chemical components what gives decreasing of the film growth rate. Thus the effect of grid thickness increasing could be compensated by an increasing of the holes diameter.
The distance between the grid and the substrate is not limited on a low end so the grid could be placed just on the substrate (in this case a diamond film would have a grid patterning). Maximal distance is limited by the filament temperature which could be higher 2000C.

The metal filament is heated up to the temperature range 1800-2800C. Under the temperatures lower than 1800C all the chemical processes have a too low rate, under the temperatures higher than 2800C there is a fast carbide transformation of the filament resulted in a filament breaking. The filaments should be made of a materials resistant to high temperature (up to 2800C), chemically resistant and resistant to the sputtering. Generally it could be tungsten or tantalum or renium wire which length should be practically selected. The increasing of the filament thickness resulted in increasing of chemical filament activation, however it should be noted that the thickness value could be limited by used power supply source.

If to heat the substrate up to lower or higher the temperatures 650-900C the surface could be coated either graphite or diamond with a large grain structure which have a bad emission properties.

If to use a carbon containing gas under concentration lower 2% emission properties are getting much worse, if the concentration higher 10% only graphite is growing on the surface. The similar statement could be considered for a methane case.

Under deposition on a silicon substrate a time less than 4 minutes is not enough for coating of uniformly distributed along the surface carbide layer, under the deposition during a time greater than 20 minutes the layer has a negative influence on the diamond film adhesion to the substrate.

Under methane concentration lower 5% the needed carbide layer is not growing, if the concentration is higher than 20% the mainly graphite film is growing.

### BRIEF DESCRIPTION OF DRAWINGS

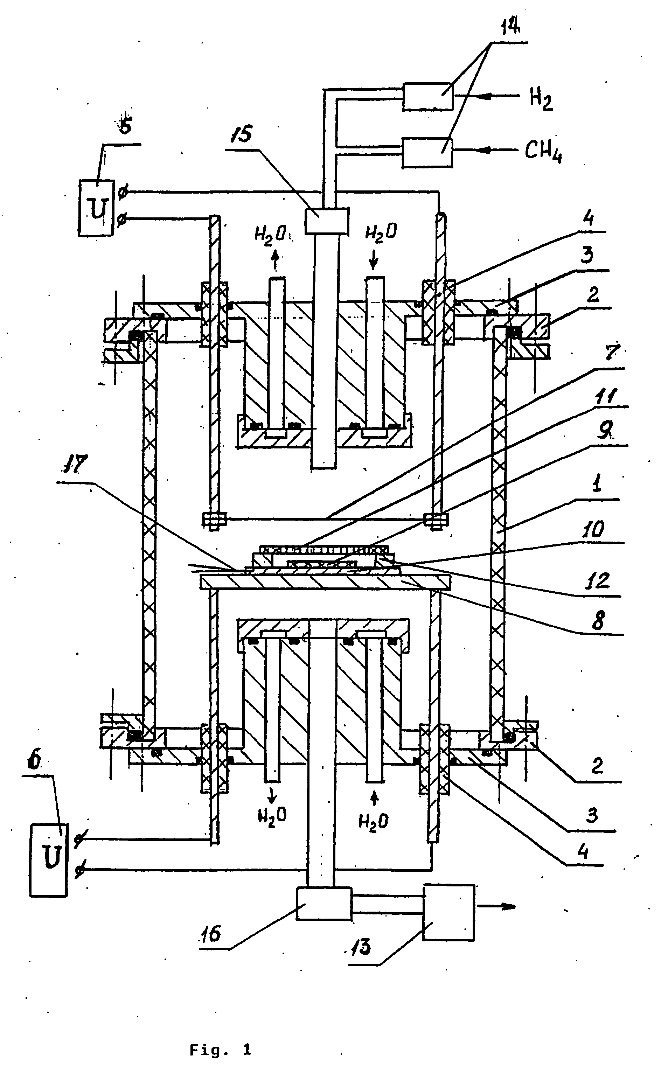

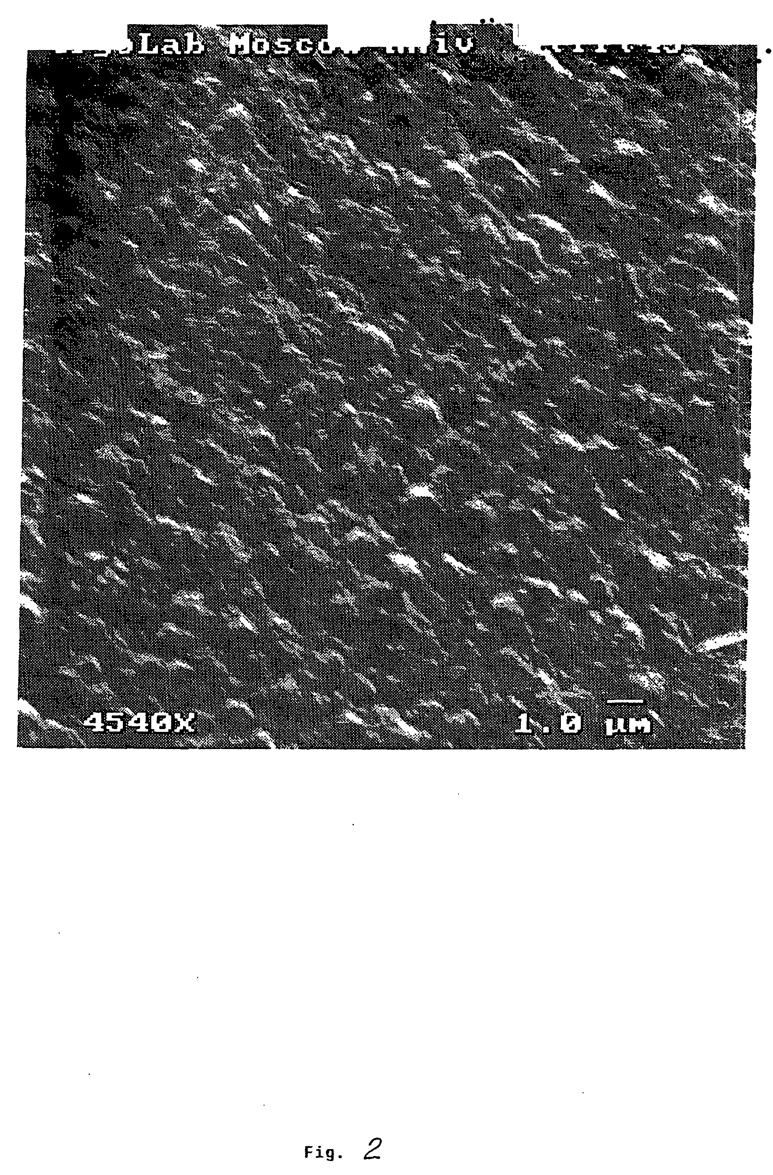

A better understanding of the present invention can be obtained by considering the Fig.1 which shows a sketch of a gas phase (CVD) reactor suitable for the method of this invention and Fig.2. showing a scanning electron microscope image of a diamond film grown by the method of this invention.

Deposition system comprises reactor tube (1), preferably made from quartz, closed and sealed by flanges (2) and (3). Flanges (3) additionally to the water cooling have isolated current plugs in (4) for an electrical power supply from the sources (5) and (6) to the hot filament (7) and a substrate heater (8). The substrate (9) is placed on the substrate holder (10) and is separated from the metal wire (7) by the protective grid (11) which is placed on a special holder (12). The distance between grid (11) and substrate (8) may be determined by thickness of holder (12). Vacuum pump (13) provides vacuum pumping. Working gases are supplied through a number of electronic mass-flow controllers (14), buffer mixture volume (15) and gas flow regulator (16). The temperature of the filament is controlled by the optical pyrometer (it is not shown on the figure), the substrate temperature is controlled by thermocouple (17), mounted into the substrate holder (10). The thermocouple contact is realized by the isolated current plug in which is similar to the (4).

### THE POSSIBLE WAYS OF REALIZATION OF THE INVENTION

The method is realized by the following way. Vacuum chamber (1) is pumped up to necessary vacuum. After evacuating the chamber the hydrogen gas is injected into the reactor through the mass-flow controller (14) in order to keep needed flow value. After the hydrogen flow rate achieves required value a gas pressure could be hold under the needed value by using controller (16). After this power supplies are switch on to heat substrate heater (8) and filament (7). The substrate and filament temperatures can be regulated by the power supply voltage. After a time needed to allow the substrate and filament to reach the required temperatures, the carbon containing gas (for example methane ) is injected into the reactor through the individual flow meter (14) under selected with the hydrogen proportion. From this moment the deposition process begins. After achievement of a determined film thickness the deposition process should be stopped by interrupting a carbon containing gas flow (for example the methane) and all the steps should be made in reverse order. After film growing up to necessary thickness (usually a few microns) it should be used a film annealing during 4-20 minutes in the hydrogen under the same temperature regime for removing a graphite layer from the film surface.

### THE EXAMPLES OF REALIZATION FOR DIAMOND FILM DEPOSITION

The metal filament was made from the tungsten wire with the thickness 0.5mm.

### Example 1. The diamond film deposition process on silicon substrate.

As a substrate it was used a silicon preliminary treated by one of the standard ways for seeding. The substrate temperature under deposition process was in range 680-850C. The filament temperature was in the range 2100-2200C. The distance between the filament and the grid was 1-6 mm, between the substrate and grid 0.1-2 mm. It should be noted that increasing of the filament-.substrate distance is decreasing a deposition rate very sharp since the chemically active radicals are generated near the filament.

### Process of deposition on silicon substrate comprises the following steps:

After evacuating the chamber up to 10⁻² Pa (10⁻⁴ Torr) the hydrogen gas is injected into the reactor up to the pressure 1-11 kPa (10-80 Torr). The power supplies are switch on to heat the substrate heater and the filament. After a time needed to allow the substrate and filament to reach the required temperatures the silicon oxide was removed in the hydrogen during 4-20 minute After this the methane gas is injected into the reactor under the relative concentration 5-20%. At this stage during 10-20 minutes of the process the silicon carbide layer is formed on the substrate surface. This layer is needed to improve the adhesion of a diamond film to the silicon substrate and to improve electron injection performances from the silicon substrate to the diamond film. In the following stage the methane concentration in the gas mixture is reduced to the range 2%- 8% and the diamond film is grown on the substrate surface with the rate 0.5 microns/hour. After the film growing up to necessary thickness (usually 1 micron) the methane flow was interrupted and film annealing in the hydrogen was performed during 4-10 minutes for removing of graphite layer from the film surface

### Example 2. The diamond film deposition process on the metal substrate.

The process has a certain difference in comparison with the deposition process on the silicon substrate. It is due the different chemical activity of the metal and the silicon. The processes of chamber pumping, gas injection and filament heating are the similar to the Example 1. However the stage of the oxide removal is not needed. Following stage is the methane injection (2-5%) into the gas flow and the diamond film is growing with the rate 0.2-0.5 microns/hour. Since the such metal as molybdenum, tungsten, tantalum have a high rate of carbides formation the special stage for carbide layer formation could be omitted. After the film was grown up to the necessary thickness (usually 1 micron) the methane flow was interrupted and followed by film annealing in the hydrogen for removal of graphite layer from the film surface.

Using the process described above, a thin nano crystalline diamond film was grown on the substrate. Referring to Fig.2, a scanning electron microscope image of the surface texture is shown of a sample of thin nano crystalline diamond film deposited by the method of this invention. The same fact was confirmed by the scanning tunneling microscopy. X-ray diffractometry showed that a typical value of the grain size is about 10-50 nm. Graphs of electrical current vs. electrical field strength showed that the "turn-on" emission voltage is very low - a few V/micron.
It was reached the emission current density 100 mA/cm², emission sites density 10⁵ per cm²
The characteristics of diamond films deposited on the metal substrates are similar to the ones for the diamond films deposited on the silicon substrates.

### THE INDUSTRIAL APPLICABILITY.

The films produced by the above described way could be applied as cold cathode emitters in flat panel displays. These films could be used in cathode luminescent light sources for projectors, jumbotron pixels where the high brightness is required. The diamond cold emitters could be used in vacuum electronic devices.

## Claims

1. A method for forming diamond films by gas phase comprising: heating the metal filament and the substrate in the hydrogen flow, injection into the flow the carbon containing gas, growing a diamond film on the substrate in mixture of hydrogen and carbon - containing gas, removing of the surplus of the graphite phase at the hydrogen distinguishing by with the goal of obtaining nano crystalline diamond films with highly effective electron emission characteristics the metal filament is to raise to a temperature within the range from about 1800 to about 2800 C, the substrate is to raise to range about 650-900 C, positioning a protective grid screen between the substrate and the metal filament under carbon containing gas concentration in gas flow 2-10%.

2. The method of claim 1 wherein the carbon containing gas is the methane which is introduced at a concentration in the range 2-8% into the gas flow ;

3. The method of claim 2 wherein the substrate is comprising of silicon, the reactor is first filled with the hydrogen flow to remove a natural silicon oxide within the temperature ranges of the metal filament and the substrate necessary for film deposition, a silicon carbide layer on the substrate is formed by introducing a methane with the concentration 5-20% into the gas flow during 4-20 minutes, the amount of methane in the gas mixture is reduced to 2-8%, the diamond film is grown, the surplus of graphite phase is removed.

## Patentansprüche

1. Verfahren zum Bilden von Diamantschichten mittels Gasphase, aufweisend:
- das Aufheizen eines Metalldrahtes und eines Substrates in einem Wasserstoffstrom,
- das Einspritzen von kohlenstoffhaltigem Gas in den Strom,
- das Abscheiden einer Diamantschicht auf dem Substrat in einer Mischung aus wasserstoff- und kohlenstoffhaltigem Gas,
- das Entfernen des Überschusses der Graphitphase aus dem Wasserstoff entsprechend dem Ziel des Erhaltens von nanokristallinen Diamantschichten mit hocheffektiven Elektronenemissionseigenschaften,
- **wobei** der Metalldraht auf eine Temperatur innerhalb des Bereiches zwischen 1800 °C und 2800 °C angehoben werden muss, während das Substrat in einen Bereich zwischen 650 °C und 900 °C angehoben werden muss,
- **das** Positionieren eines Schutzgitterschirms zwischen dem Substrat und dem Metalldraht unter einer kohlenstoffhaltigen Gaskonzentration im Gasstrom von 2 bis 10 %.

2. Verfahren nach Anspruch 1,
In welchem das kohlenstoffhaltige Gas Methan ist, welches in einer Konzentration in dem Bereich von 2 bis 8 % in den Gasstrom eingeführt wird.

3. Verfahren nach Anspruch 2,
**In welchem** das Substrat Silizium aufweist, der Reaktor zunächst mit Wasserstofffluss gefüllt wird, um natürliche Siliziumoxide innerhalb der für die Schichtabscheidung erforderlichen Temperaturbereiche des Metalldrahtes und des Substrates zu entfernen,
**wobei** eine Siliziumcarbidschicht auf dem Substrat durch Einführen von Methan mit einer Konzentration von 5 bis 20 % in den Gasstrom während 4 bis 20 Minuten gebildet wird,
**wobei** die Menge an Methan in der Gasmischung auf 2 bis 8 % reduziert wird, die Diamantschicht wächst und der Überschuss an Graphitphase entfernt wird.

## Revendications

1. Procédé de formation de films de diamant en phase gazeuse comprenant : le chauffage d'un filament métallique et d'un substrat dans un courant d'hydrogène, l'injection dans le courant d'hydrogène d'un gaz contenant du carbone, la formation d'un film de diamant sur le substrat dans le mélange d'hydrogène et de gaz contenant du carbone, l'élimination du surplus de la phase graphite, de l'hydrogène, dans le but d'obtenir des films de diamant nano-cristallins présentant des caractéristiques d'émission d'électrons hautement efficaces, avec augmentation de la température du filament métallique jusqu'à une valeur située entre environ 1800 et 2800 C, augmentation de la température du substrat jusqu'à environ 650 - 900 C, positionnement d'un écran à grille protectrice entre le substrat et le filament, à une concentration du gaz contenant du carbone dans le courant gazeux de 2 - 10 %.

2. Procédé selon la revendication 1, dans lequel Je gaz contenant du carbone est le méthane, qui est introduit à une concentration se situant dans la plage de 2-8 % dans le courant gazeux.

3. Procédé selon la revendication 2, dans lequel le substrat est constitué de silicium, le réacteur est d'abord rempli avec le courant d'hydrogène pour éliminer l'oxyde de silicium naturel dans les plages de température du filament métallique et du substrat nécessaires pour le dépôt du film, une couche de carbure de silicium se trouve formée sur le substrat par introduction de méthane à la concentration de 5 -20 % dans le courant gazeux pendant 4 à 20 minutes, la quantité de méthane dans le mélange gazeux est réduite à 2-8%, le film de diamant est formé, le surplus de phase graphite est éliminé.
